(19) **Europäisches Patentamt / European Patent Office / Office européen des brevets**

(11) **EP 2 710 704 B1**

(12) **FASCICULE DE BREVET EUROPEEN**

(45) Date de publication et mention
de la délivrance du brevet:
**27.07.2016 Bulletin 2016/30**

(21) Numéro de dépôt: **12728718.3**

(22) Date de dépôt: **16.05.2012**

(51) Int Cl.:
*H02J 7/00* <sup>(2006.01)</sup> *B60L 11/18* <sup>(2006.01)</sup>
*G01R 31/36* <sup>(2006.01)</sup>

(86) Numéro de dépôt international:
**PCT/FR2012/051115**

(87) Numéro de publication internationale:
**WO 2012/156650 (22.11.2012 Gazette 2012/47)**

(54) **SYSTÈME ET PROCÉDÉ D'ESTIMATION DE L'INSTANT DE FIN DE CHARGE D'UNE BATTERIE**

SYSTEM UND VERFAHREN ZUR SCHÄTZUNG DES ENDES DES LADEVORGANGES EINER BATTERIE

SYSTEM AND METHOD FOR ESTIMATING THE END-OF-CHARGE TIME OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.05.2011 FR 1154383**

(43) Date de publication de la demande:
**26.03.2014 Bulletin 2014/13**

(73) Titulaire: **Renault S.A.S.**
**92100 Boulogne-Billancourt (FR)**

(72) Inventeurs:
- **BEN-AICHA, Fehd**
  **F-78280 Guyancourt (FR)**
- **DRIEMEYER-FRANCO, Ana-Lucia**
  **F-78180 Montigny-le-bretonneux (FR)**
- **OBERTI, Claire**
  **F-75015 Paris (FR)**

(56) Documents cités:
| | |
|---|---|
| EP-A1- 0 731 546 | EP-A2- 1 231 476 |
| WO-A1-00/23810 | WO-A1-2007/045673 |
| US-A1- 2008 231 284 | |

**Description**

L'invention a pour domaine technique les systèmes de charge d'éléments de stockage d'énergie électrique.

L'estimation du temps de fin de charge d'une batterie représente une information importante pour les utilisateurs de ce type d'organe de stockage d'énergie. Cette information facilite par exemple une meilleure utilisation du temps d'attente de la charge de la batterie pour l'utilisateur. Cette information permet également à des systèmes embarqués de mieux gérer l'utilisation de l'énergie dans un véhicule électrique ou hybride afin d'augmenter l'autonomie du véhicule.

La demande de brevet EP 0 731 546 A1 divulgue un chargeur de batterie capable d'afficher le temps de charge nécessaire. Il a pour inconvénient d'être imprécis.

On identifiera également les documents WO 00/23810 A1, US 2008/231284 A1, WO 2007/045673 A1 et enfin EP 1 231 476 A2 qui décrivent de même un système et un procédé selon le preambule des revendications independantes 1 et 6.

Un but de l'invention est d'estimer avec précision l'instant de fin de charge d'une batterie.

Un autre but de l'invention est d'estimer l'instant de fin de charge d'une batterie soumise à un vieillissement.

L'invention est définie par les caractéristiques des revendications independantes. Les modes de réalisation préférés sont définis par les revendications dependantes 1 et 6.

Dans un mode de réalisation, on propose un système d'estimation de l'instant de fin de charge d'une batterie connectée à un chargeur de batterie dans un véhicule automobile. Le système comprend un moyen de détermination de l'état de charge d'une batterie, un moyen de détermination de la puissance de charge du chargeur de batterie et un moyen de détermination d'un instant de fin de charge. Par état de charge, on entend le rapport entre la charge courante et la charge maximale.

Le système de détermination présente l'avantage de tenir compte des différences entre début et fin de charge dans la détermination de la durée de charge restante.

Le moyen de détermination d'un instant de fin de charge peut comprendre un moyen de détermination d'une durée de début de charge et un moyen de détermination d'une durée de fin de charge.

Le système peut comprendre un moyen de correction de l'instant de fin de charge en fonction du vieillissement de la batterie relié en sortie du moyen de détermination d'un instant de fin de charge et apte à modifier l'instant de fin de charge en fonction de l'état de vieillissement de la batterie.

Le moyen de détermination d'un instant de fin de charge peut comprendre un moyen de modélisation de la batterie et un moyen de modélisation de l'instant de fin de charge.

Le moyen de modélisation de la batterie permet de tenir compte des caractéristiques physiques de la batterie qui sont non linéaires afin d'améliorer l'estimation de l'instant de fin de charge.

Le système de détermination présente alors l'avantage d'une mise au point plus rapide et une plus grande adaptabilité à différentes batteries.

Le moyen de modélisation de l'instant de fin de charge peut être apte à déterminer l'instant de fin de charge en fonction d'un modèle mémorisé, de coefficients reçus d'un moyen de modélisation de la batterie, d'une valeur de charge maximale de la batterie reçu d'une mémoire, d'une mesure de l'état de charge, d'une mesure de la puissance de charge, et d'une mesure de la température de la batterie reçu d'un capteur de température de la batterie.

Le système peut comprendre un moyen de détermination du vieillissement de la batterie relié entre la mémoire et le moyen de détermination de l'instant de fin de charge.

Le système peut comprendre un filtre en aval du moyen de détermination de l'état de charge d'une batterie et du moyen de détermination de la puissance de charge du chargeur de batterie permettant d'atténuer les bruits de mesure.

Un tel système d'estimation de l'instant de fin de charge peut être intégré dans un dispositif de contrôle d'une batterie ou dans un dispositif de contrôle d'un groupe motopropulseur de véhicule automobile connecté à une batterie.

Il est également proposé un procédé de détermination de l'instant de fin de charge d'une batterie, dans lequel on détermine l'état de charge d'une batterie, on détermine la puissance de charge du chargeur de batterie et on détermine un instant de fin de charge en fonction de l'état de charge et de la puissance de charge.

On peut déterminer une correction de l'instant de fin de charge en fonction du vieillissement de la batterie.

On peut déterminer l'instant de fin de charge en fonction d'un modèle, d'une valeur de charge maximale mémorisée, d'une mesure de l'état de charge, d'une mesure de la puissance de charge, et d'une mesure de la température de la batterie.

D'autres buts, caractéristiques et avantages apparaîtront à la lecture de la description suivante donnée uniquement en tant qu'exemple non limitatif et faite en référence aux dessins annexés sur lesquels :

- la figure 1 illustre un premier mode de réalisation d'un système de détermination selon l'invention, et
- la figure 2 illustre un deuxième mode de réalisation d'un système de détermination selon l'invention.

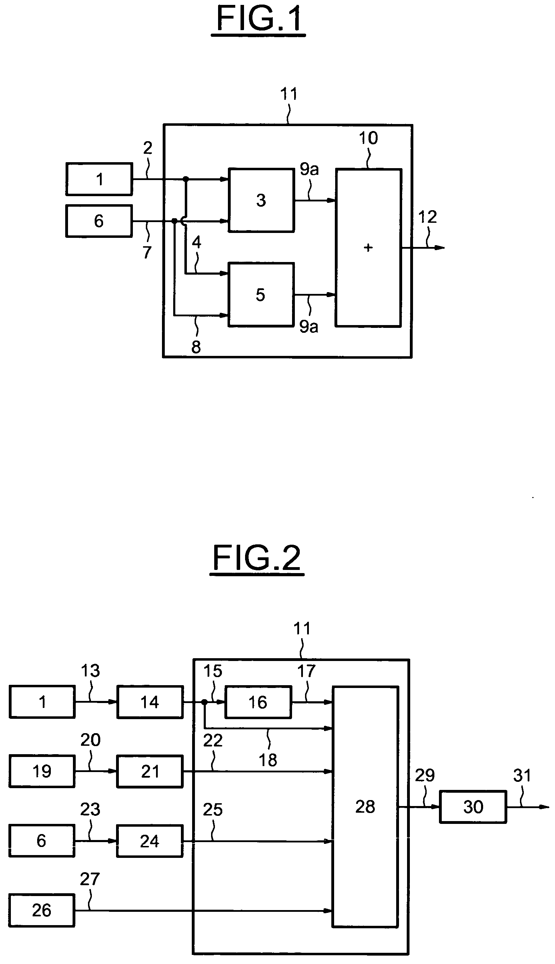

Sur la figure 1, on peut voir un moyen de détermination 1 de l'état de charge relié par une connexion 2 à un moyen de détermination 3 de la durée de début de charge, et par une dérivation 4 de la connexion 2 à un moyen de détermination 5 de la durée de fin de charge. Un moyen de détermination 6 de la puissance du chargeur de batterie est relié par la connexion 7 au moyen de détermination 3 de la durée de début de charge, et par une dérivation 8 de la connexion 7 au moyen de détermination 5 de la durée de fin de charge.

Un sommateur 10 est relié par une connexion 9a au moyen de détermination 3 de la durée de début de charge, et par une connexion 9b au moyen de détermination 5 de la durée de fin de charge.

Une connexion 12 est reliée en sortie du sommateur 10.

Un moyen de détermination 11 de l'instant de fin de charge comprend le sommateur 10, le moyen de détermination 3 de la durée de début de charge, et le moyen de détermination 5 de la durée de fin de charge.

Dans ce premier mode de réalisation, l'estimation de l'instant de fin de charge repose sur une méthode empirique, en utilisant deux cartographies. L'estimation de la durée de charge dépend de la puissance de charge et de l'état de charge de la batterie. Les cartographies utilisées sont donc des cartographies comprenant deux entrées et une sortie.

Lors de la charge d'une batterie, on distingue deux phases pour une charge complète. Une charge complète correspond à la charge d'une batterie présentant un état de charge égal à 0% de la charge totale jusqu'à un état de charge égal à 100% de la charge totale.

Une première phase, nommée « début de charge », correspond à une phase au cours de laquelle la puissance de charge est constante.

Une deuxième phase, nommée « fin de charge », correspond une phase au cours de laquelle la puissance est réduite par paliers.

La cartographie correspondant à la première phase est comprise dans le moyen de détermination 3 de la durée de début de charge.

La cartographie correspondant à la deuxième phase est comprise dans le moyen de détermination 5 de la durée de fin de charge.

Le sommateur 10 réalise la somme des durées obtenues en sortie du moyen de détermination 3 de la durée de début de charge et du moyen de détermination 5 de la durée de fin de charge.

En vieillissant, les batteries présentent une diminution de leur capacité, et donc de leur temps de charge.

Toutefois, les cartographies comprises dans le moyen de détermination 3 de la durée de début de charge et dans le moyen de détermination 5 de la durée de fin de charge sont établies pour des charges complètes correspondant à des batteries neuves.

L'état de charge mesuré pour une batterie vieillissante ne correspond donc pas à l'état de charge d'une batterie neuve. La durée de charge déterminée est ainsi erronée sans une correction due au vieillissement. On rappelle qu'un état de charge est exprimé comme un rapport entre la charge courante et la charge maximale de la batterie.

Afin de conserver une estimation fiable de la durée de charge tout au long de la vie d'une batterie, il est nécessaire de corriger les valeurs d'états de charge transmises au moyen de détermination 3 de la durée de début de charge et au moyen de détermination 5 de la durée de fin de charge, selon le deuxième mode de réalisation de l'invention décrit en référence à la figure 2.

Pour cela, un moyen de correction de l'instant de fin de charge en fonction du vieillissement de la batterie peut être inséré en aval du moyen de détermination 1 de l'état de charge. En fonction d'une valeur mémorisée de la charge emmagasinée à l'issue d'une charge complète, le moyen de détermination 1 de l'état de charge est apte à déterminer l'état de vieillissement de la batterie. Il est également apte à modifier la valeur de l'état de charge déterminée par le moyen de détermination 1 de l'état de charge de sorte que la valeur de l'état de charge émise en sortie à destination du moyen de détermination 3 de la durée de début de charge et du moyen de détermination 5 de la durée de fin de charge intègre une correction de l'état de vieillissement.

La correction de l'état de vieillissement peut être par exemple un facteur multiplicatif de l'état de charge mesuré. Le facteur multiplicatif peut être issu du rapport entre la charge totale d'une batterie vieillissante et la charge totale de la même batterie neuve. Le facteur peut être également issu d'une loi comparant l'évolution de l'état de charge d'une batterie vieillissante à une batterie neuve. Sur la figure 2, on peut voir un moyen de détermination 11 de l'instant de fin de charge comprenant un moyen de modélisation 16 de la batterie et un moyen d'estimation 28 de l'instant de fin de charge.

Un moyen de détermination 1 de l'état de charge est relié par une connexion 13 à un premier filtre 14. Le filtre 14 est relié en sortie au moyen de modélisation 16 de la batterie, lui-même relié en sortie à une connexion 17. Une dérivation 18 est par ailleurs connectée à la connexion 15.

Une mémoire 19 est reliée par la connexion 20 à un moyen de détermination du vieillissement de la batterie 21, lui-même connecté en sortie à une connexion 22.

Un moyen de détermination 6 de la puissance du chargeur de batterie est relié par une connexion 23 à un deuxième filtre 24, lui-même relié en sortie à une connexion 25.

Un moyen de détermination de la température 26 est relié en sortie à une connexion 27.

Le moyen d'estimation 28 de l'instant de fin de charge est connecté en entrée aux connexions 17, 18, 22, 25 et 27. Un troisième filtre 30 est relié en entrée par la connexion 29 au moyen d'estimation 28 de l'instant de fin de charge et en sortie à une connexion 31.

Le moyen d'estimation 28 de l'instant de fin de charge permet de modéliser très précisément la physique impliquée dans la charge d'une batterie. Il permet de gagner des ressources mémoires et du temps sur la mise au point d'un système d'estimation de l'instant de fin de charge d'une batterie, par rapport à un système qui utiliserait des cartographies pour caractériser le temps de charge en fonction de chaque point de fonctionnement possible, c'est-à-dire pour une série de températures prédéfinies, de durées de vie prédéfinies, de puissances de charge prédéfinies et d'états de charge prédéfinis.

Alternativement, le moyen de détermination du vieillissement de la batterie 21 peut être supprimé, auquel cas le moyen de détermination 28 de l'instant de fin de charge prend en compte directement la valeur mémorisée dans la mémoire 19.

Le deuxième mode de réalisation emploie un modèle physique de la charge et de la décharge de la batterie afin de déterminer l'instant de fin de charge. Le modèle physique caractérise la durée de charge complète en fonction de la température de la batterie, de la puissance de charge de la batterie, de l'état de charge et du vieillissement de la batterie.

Afin d'obtenir ce modèle, on commence par modéliser la batterie à charger. Pour cela on exprime l'état de charge de la batterie SOC en fonction du courant de batterie $I^{bat}$, de la température de la batterie T, de la capacité de la batterie neuve $Q_0^{bat,max}$ et de la capacité de la batterie $Q^{bat,max}(T,t)$ à l'instant t et à la température T.

$$\frac{dSOC}{dt} = \frac{I^{bat}}{Q^{bat,max}(T,t)}$$

La capacité de la batterie se dégrade en fonction de sa température et de son état de charge. On en déduit une expression reliant tension, courant et résistance :

$$U^{bat} = U_0(T,SOC) + I^{bat} \cdot R(T,SOC) \qquad (Eq.\ 2)$$

Avec $U^{bat}$ : la tension de la batterie,
$U_0(T,SOC)$ : la tension à vide de la batterie,
$R(T,SOC)$ : la résistance de la batterie.

La tension à vide et la résistance interne de la batterie sont soit issues de cartographies empiriques, soit des fonctions issues de la théorie de l'électrochimie des batteries, soit issues d'une combinaison des deux.

L'élaboration d'un algorithme d'estimation tenant compte spécifiquement des non linéarités de la résistance et de la tension à vide permet d'augmenter la précision d'estimation.

Pour cela, on considère que la capacité de la batterie neuve $Q^{bat,max}$ est un paramètre de l'équation 1.

La puissance de charge de la batterie peut être exprimée de la façon suivante :

$$P_{ch} = U^{bat} \cdot I^{bat} \qquad (Eq.\ 3)$$

Si, dans l'équation 3, on substitue $U^{bat}$ par son expression tirée de l'équation 2, on obtient l'expression suivante :

$$P_{ch} = I^{bat} \cdot \left[U_0(T,SOC) + I^{bat} \cdot R(T,SOC)\right] \qquad (Eq.\ 4)$$

L'équation 4 peut être développée pour obtenir l'équation suivante :

$$P_{ch} = I^{bat} \cdot U_0(T,SOC) + \left(I^{bat}\right)^2 \cdot R(T,SOC) \qquad (Eq.\ 5)$$

La résolution de cette équation permet de déterminer le courant $I^{bat}$ :

$$I^{bat} = \frac{-U_0(T,SOC) + \sqrt{[U_0(T,SOC)]^2 + 4 \cdot P_{ch} \cdot R(T,SOC)}}{2 \cdot R(T,SOC)} \quad (Eq. \ 6)$$

En remplaçant $I^{bat}$ par son expression tirée de l'équation 6 dans l'équation 1, on obtient :

$$\frac{dSOC}{dt} = \frac{-U_0(T,SOC) + \sqrt{[U_0(T,SOC)]^2 + 4 \cdot P_{ch} \cdot R(T,SOC)}}{2 \cdot R(T,SOC) \cdot Q^{bat,max}(T,t)} \quad (Eq. \ 7)$$

L'équation 7 peut être reformulée pour exprimer la dérivée du temps dt :

$$dt = dSOC \cdot \frac{2 \cdot R(T,SOC) \cdot Q^{bat,max}(T,t)}{-U_0(T,SOC) + \sqrt{[U_0(T,SOC)]^2 + 4 \cdot P_{ch} \cdot R(T,SOC)}} \quad (Eq. \ 8)$$

L'intégration terme à terme de l'équation 8 permet de déterminer l'instant de fin de charge $t_{ch}^f$ étant donné l'instant de début de charget $t_{ch}^i$ .

$$t_{ch}^f = t_{ch}^i + \int_{S_i}^{S_f} \frac{2 \cdot R(T,SOC) \cdot Q^{bat,max}(T,t)}{-U_0(T,SOC) + \sqrt{[U_0(T,SOC)]^2 + 4 \cdot P_{ch} \cdot R(T,SOC)}} \cdot dSOC \quad (Eq. \ 9)$$

Avec

$S_i$ : la valeur de l'état de charge SOC en début de charge
$S_f$ : la valeur de l'état de charge SOC en fin de charge, qui peut être différente de 100%.
La difficulté réside dans l'intégration de l'équation 7 du fait de la complexité des expressions de la tension à vide $U_0$ et de la résistance R.

Afin de résoudre cette difficulté, une méthode de linéarisation de la tension à vide Uo et de la résistance R est proposée.
Comme décrit plus haut, la courbe de tension à vide en fonction de l'état de charge présente deux points d'inflexion délimitant trois zones distinctes. On estime que dans chacune de ces zones, la tension à vide varie linéairement avec l'état de charge. On peut associer un indice k à chacun des trois intervalles.
Pour chacune des zones, la tension à vide peut être exprimée sous la forme de l'équation suivante :

$$U_0 = \alpha_k \cdot SOC + \beta_k \quad (Eq. \ 10)$$

Avec :

- k : un indice variant entre 0 et 2 et désignant l'une des trois zones ; on peut bien sûr découper la courbe de tension à vide en plus de trois zones ;
- $\alpha_k$ et $\beta_k$ : deux coefficients

Le même raisonnement peut être appliqué à la variation de la résistance interne R en fonction de l'état de charge de la batterie. La résistance interne R varie selon une relation polynomiale inverse et comprend deux zones dans lesquelles le taux de variation est différent. L'abscisse de la borne entre les deux zones est différente des abscisses des bornes séparant les zones relatives à la tension à vide.
Pour chacune des zones, la résistance peut être exprimée sous la forme de l'équation suivante :

$$R = \rho_k \cdot SOC + \tau_k \qquad \qquad (Eq. \ 11)$$

Avec :

- k : un indice variant égal à 0 ou à 1 et désignant l'une des deux zones ; on peut bien sûr découper la courbe de résistance interne en plus de deux zones ;
- $\rho_k$ et $\tau_k$ deux coefficients.

Les coefficients $\alpha_k$, $\beta_k$, $\rho_k$ et $\tau_k$ sont déterminés de façon à approcher les relations de la tension à vide et de la résistance interne par des fonctions linéaires. De plus, les coefficients peuvent varier en fonction de la température et du type de batterie.

Si on note ki l'indice d'intervalle auquel appartient la valeur initiale Si de l'état de charge SOC et kf l'indice d'intervalle auquel appartient la valeur finale $S_f$ du SOC, et que l'on considère les équations 10 et 11, l'expression (Eq. 9) définissant l'instant de fin de charge se transforme en l'expression suivante :

$$t_{ch}^f = t_{ch}^i + \sum_{ki \le k \le kf} \int_{S_i}^{S_f} f_k \left( T, SOC, Q^{bat,max}, P_{ch} \right) \cdot dSOC \qquad \qquad (Eq. \ 12)$$

L'estimation du temps de charge final passe par une succession d'étapes. On détermine d'abord l'indice ki correspondant à l'état de charge courant. L'indice ki est compris entre 0 et 3.

On applique ensuite l'équation 12 en remplaçant les valeurs de la résistance et de la tension à vide de l'équation 9 par les expressions linéaires des équations 10 et 11, en ayant pris soin de choisir les coefficients correspondant à l'indice ki déterminé. Les coefficients de ces équations sont préalablement déterminés.

Le système de détermination peut être intégré dans le calculateur principal du groupe motopropulseur ou dans le calculateur de la batterie.

Une application du deuxième mode de réalisation du système d'estimation de l'instant de fin de charge est d'optimiser la stratégie de charge de la batterie.

Le temps de charge de la batterie est réduit lorsque le système de détermination est utilisé. En effet, le système de détermination permet de minimiser le temps de charge de la batterie tout en minimisant la dispersion de la charge de la batterie. La minimisation de la dispersion de la charge de la batterie est obtenue en maximisant la puissance acceptée par la batterie au cours de la charge. Ceci est facilité par l'expression analytique du modèle du système de détermination.

$$t_{ch}^f = f \left( I, SOC_f, T, P^{bat,max} \right) \qquad \qquad (Eq. \ 13)$$

avec $P^{bat,max}$ : la puissance maximale que peut accepter la batterie sans compromette sa durée de vie.

On note $\sigma_{soc}$ la dispersion de la valeur de l'état de charge SOC. La dispersion de la valeur de l'état de charge de la batterie est dépendant de la dispersion du courant $\sigma_I$, elle-même dépendante de la température T et du courant I. Plus le courant augmente, plus le temps de charge diminue. Parallèlement, plus le courant diminue, plus la dispersion de l'état de charge diminue, et plus la contrainte sur la durée de vie de la batterie est respectée. Il existe ainsi un problème d'optimisation du courant de charge. Ce problème peut être résolu par des méthodes analytiques ou numériques.

Une autre application du deuxième mode de réalisation du système d'estimation de l'instant de fin de charge est d'optimiser les instants de charge du véhicule de façon interactive avec l'utilisateur afin d'améliorer la durabilité, l'autonomie et la disponibilité du véhicule. Le système permet d'améliorer l'autonomie du véhicule ainsi que sa disponibilité pour l'utilisateur. Par l'intermédiaire d'une interface homme machine, l'utilisateur peut être informé de la charge restante, de la durée de charge nécessaire pour une charge complète et de la prévision d'un instant de recharge. L'utilisateur peut également recevoir ces informations de façon synthétique à l'intérieur d'une application de navigation assistée par satellite (par ex, de type GPS) ou tout autre programme de planification de trajet.

## Revendications

1. Système d'estimation de l'instant de fin de charge d'une batterie connectée à un chargeur de batterie dans un véhicule automobile, comprenant un moyen de détermination (1) de l'état de charge d'une batterie, un moyen de détermination (6) de la puissance de charge du chargeur de batterie et un moyen de détermination (11) d'un instant de fin de charge, le système étant **caractérisé en ce que** le moyen de détermination (11) d'un instant de fin de charge comprend un moyen de détermination (3) d'une durée de début de charge et un moyen de détermination (5) d'une durée de fin de charge, le début de charge étant une phase au cours de laquelle la puissance de charge est constante et la fin de charge étant une phase au cours de laquelle la puissance de charge est réduite par paliers, et **en ce qu'**il comprend un moyen de correction de l'instant de fin de charge en fonction du vieillissement de la batterie relié en sortie du moyen de détermination (11) d'un instant de fin de charge et apte à modifier l'instant de fin de charge déterminé par le moyen de détermination (11) en fonction de l'état de vieillissement de la batterie.

2. Système selon la revendication 1, dans lequel le moyen de détermination (11) d'un instant de fin de charge comprend un moyen de modélisation (16) de la batterie utilisant une linéarisation de la tension à vide et de la résistance interne de la batterie, et un moyen d'estimation (28) de l'instant de fin de charge.

3. Système selon la revendication 2, dans lequel le moyen d'estimation (28) de l'instant de fin de charg.e est apte à déterminer l'instant de fin de charge en fonction d'un modèle mémorisé, de coefficients reçus d'un moyen de modélisation de la batterie, d'une valeur de charge maximale de la batterie reçue d'une mémoire (19), d'une mesure de l'état de charge, d'une mesure de la puissance de charge, et d'une mesure de la température de la batterie reçue d'un capteur de température (26) de la batterie.

4. Système selon la revendication 3, comprenant un moyen de détermination (21) du vieillissement de la batterie relié entre la mémoire (19) et le moyen de détermination (11) de l'instant de fin de charge.

5. Système selon l'une des revendications 3 ou 4, comprenant un filtre en aval du moyen de détermination (1) de l'état de charge d'une batterie et du moyen de détermination (6) de la puissance de charge du chargeur de batterie permettant d'atténuer les bruits de mesure.

6. Procédé de détermination de l'instant de fin de charge d'une batterie, dans lequel on détermine l'état de charge d'une batterie, on détermine la puissance de charge du chargeur de batterie et on détermine un instant de fin de charge en fonction de l'état de charge et de la puissance de charge,
le procédé étant **caractérisé en ce qu'**on détermine une durée de début de charge et une durée de fin de charge, le début de charge étant une phase au cours de laquelle la puissance de charge est constante et la fin de charge étant une phase au cours de laquelle la puissance de charge est réduite par paliers, et **en ce qu'**on détermine une correction de l'instant de fin de charge déterminé, en fonction du vieillissement de la batterie.

7. Procédé selon la revendication 6, dans lequel on détermine l'instant de fin de charge en fonction d'un modèle, d'une valeur de charge maximale mémorisée, d'une mesure de l'état de charge, d'une mesure de la puissance de charge, et d'une mesure de la température de la batterie.

**Patentansprüche**

1. System zur Schätzung des Endes des Ladevorganges einer Batterie, die mit einem Batterieladegerät in einem Kraftfahrzeug verbunden ist, das ein Mittel (1) zur Bestimmung des Ladezustandes einer Batterie, ein Mittel (6) zur Bestimmung der Ladeleistung des Batterieladegeräts und ein Mittel (11) zur Bestimmung eines Endes des Ladevorganges aufweist, wobei das System **dadurch gekennzeichnet ist, dass** das Mittel (11) zur Bestimmung eines Endes des Ladevorganges ein Mittel (3) zur Bestimmung einer Dauer des Beginns des Ladevorganges und ein Mittel zur Bestimmung (5) einer Dauer des Endes des Ladevorganges aufweist, wobei der Beginn des Ladevorganges eine Phase ist, während der die Ladeleistung konstant ist, und das Ende des Ladevorganges eine Phase ist, während der die Ladeleistung stufenweise verringert wird, und dadurch, dass es ein Mittel zur Korrektur des Endes des Ladevorganges in Abhängigkeit von der Alterung der Batterie aufweist, das am Ausgang des Mittels (11) zur Bestimmung eines Endes des Ladevorganges angeschlossen ist und geeignet ist, das durch das Bestimmungsmittel (11) bestimmte Ende des Ladevorganges in Abhängigkeit von dem Alterungszustand der Batterie zu ändern.

2. System nach Anspruch 1, wobei das Mittel zur Bestimmung (11) eines Endes des Ladevorgangs ein Mittel (16) zur Modellierung der Batterie unter Verwendung einer Linearisierung der Leerspannung und des Innenwiderstandes der Batterie und ein Mittel (28) zur Schätzung des Endes des Ladevorganges aufweist.

**3.** System nach Anspruch 2, wobei das Mittel (28) zur Schätzung des Endes des Ladevorganges geeignet ist, das Ende des Ladevorganges in Abhängigkeit von einem gespeicherten Modell, von einem Mittel zur Modellierung der Batterie empfangenen Koeffizienten, einem von einem Speicher (19) empfangenen maximalen Ladewert der Batterie, einer Messung des Ladezustandes, einer Messung der Ladeleistung und einer von einem Temperatursensor (26) der Batterie empfangenen Messung der Temperatur der Batterie zu bestimmen.

**4.** System nach Anspruch 3, das ein Mittel (21) zur Bestimmung der Alterung der Batterie aufweist, das zwischen dem Speicher (19) und dem Mittel (11) zur Bestimmung des Endes des Ladevorganges angeschlossen ist.

**5.** System nach einem der Ansprüche 3 oder 4, das ein dem Mittel (1) zur Bestimmung des Ladezustandes einer Batterie und dem Mittel (6) zur Bestimmung der Ladeleistung des Batterieladegeräts vorgeschaltetes Filter aufweist, das das Dämpfen des Messrauschens ermöglicht.

**6.** Verfahren zum Bestimmen des Endes des Ladevorganges einer Batterie, in dem der Ladezustand einer Batterie bestimmt wird, die Ladeleistung des Batterieladegeräts bestimmt wird und ein Ende des Ladevorganges in Abhängigkeit vom Ladezustand und der Ladeleistung bestimmt wird, wobei das Verfahren **dadurch gekennzeichnet ist, dass** eine Dauer des Beginns des Ladevorganges und eine Dauer des Endes des Ladevorganges bestimmt werden, wobei der Beginn des Ladevorganges eine Phase ist, während der die Ladeleistung konstant ist, und das Ende des Ladevorganges eine Phase ist, während der die Ladeleistung stufenweise verringert wird, und dadurch, dass eine Korrektur des bestimmten Endes des Ladevorganges in Abhängigkeit von der Alterung der Batterie bestimmt wird.

**7.** Verfahren nach Anspruch 6, wobei das Ende des Ladevorganges in Abhängigkeit von einem Modell, einem gespeicherten maximalen Ladewert, einer Messung des Ladezustandes, einer Messung der Ladeleistung und einer Messung der Temperatur der Batterie bestimmt wird.

**Claims**

**1.** System for estimating the charging end time of a battery connected to a battery charger in an automotive vehicle, comprising a means (1) for evaluating the charging state of a battery, a means (6) for evaluating the charging power of the battery charger, and a means (11) for evaluating a charging end time, the system being **characterized in that** the means (11) for evaluating a charging end time comprises a means (3) for evaluating a start-of-charging duration, and a means (5) for evaluating an end-of-charging duration, the "start-of-charging" being a phase during which the charging power is constant and the "end-of-charging" being a phase during which the charging power is reduced in steps, and **in that** it comprises a means for correcting the charging end time depending on the ageing of the battery, which means is connected on the output side to the means (11) for evaluating a charging end time, and able to modify the charging end time evaluated by the evaluation means (11) depending on the ageing state of the battery.

**2.** System according to Claim 1, in which the means (11) for evaluating a charging end time comprises a means (16) for modeling the battery using a linearization of the open-circuit voltage and the internal resistance of the battery, and a means (28) for estimating the charging end time.

**3.** System according to Claim 2, in which the means (28) for estimating the charging end time is able to evaluate the charging end time as a function of a memorized model, of coefficients received from a means for modeling the battery, of a maximum charging value of the battery received from a memory (19), of a measurement of the charging state, of a measurement of the charging power, and of a measurement of the temperature of the battery received from a sensor (26) of the temperature of the battery.

**4.** System according to Claim 3, comprising a means (21) for evaluating the ageing of the battery, which means is connected between the memory (19) and the means (11) for evaluating the charging end time.

**5.** System according to either of Claims 3 and 4, comprising a filter downstream of the means (1) for evaluating the charging state of a battery, and of the means (6) for evaluating the charging power of the battery charger, allowing measurement noise to be attenuated.

**6.** Method for evaluating the charging end time of a battery, in which the charging state of a battery is evaluated, the charging power of the battery charger is evaluated, and a charging end time is evaluated depending on the charging state and the charging power, the method being **characterized in that** a start-of-charging duration and an end-of-charging duration are evaluated, the "start-of-charging" being a phase during which the charging power is constant and the "end-of-charging" being a phase during which the charging power is reduced in steps, and **in that** a correction to the evaluated charging end time is evaluated depending on the ageing of the battery.

7. Method according to Claim 6, in which the charging end time is evaluated as a function of a model, of a memorized maximum charging value, of a measurement of the charging state, of a measurement of the charging power, and of a measurement of the temperature of the battery.

## FIG.1

## FIG.2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0731546 A1
- WO 0023810 A1
- US 2008231284 A1
- WO 2007045673 A1
- EP 1231476 A2